Europäisches Patentamt

European Patent Office

Office européen des brevets

(19)

(11) Veröffentlichungsnummer: **0 049 679**

**A1**

(12) **EUROPÄISCHE PATENTANMELDUNG**

(21) Anmeldenummer: **81730094.0**

(22) Anmeldetag: **18.09.81**

(51) Int. Cl.³: **H 03 K 19/007**

(30) Priorität: **04.10.80 DE 3037905**

(43) Veröffentlichungstag der Anmeldung:
**14.04.82 Patentblatt 82/15**

(84) Benannte Vertragsstaaten:
**AT BE CH DE FR GB IT LI NL**

(71) Anmelder: **Licentia Patent-Verwaltungs-GmbH**
**Theodor-Stern-Kai 1**
**D-6000 Frankfurt/Main 70(DE)**

(72) Erfinder: **Lotz, Alfred, Ing. grad.**
**Büchsenweg 14**
**D-1000 Berlin 51(DE)**

(74) Vertreter: **Lertes, Kurt, Dr. et al,**
**Licentia Patent-Verwaltungs-GmbH Theodor-Stern-Kai**
**1**
**D-6000 Frankfurt/M 70(DE)**

(54) **Fehlersichere logische Verknüpfungsschaltung.**

(57) Die Anmeldung bezieht sich auf eine Schaltungsanordnung zur logischen Verknüpfung wechselspannungsförmiger Eingangssignale zu einem wechselspannungsförmigen Ausgangssignal durch Gleichrichtung der Eingangssignale zu einem Gleichstromsignal, das eine Schwingungsschaltung mit Verstärker steuert. Die Erfindung besteht darin, daß an den Eingängen zur galvanischen Trennung Kondensatoren (5, 6) mit 4 diagonal genenüberliegenden Anschlüssen vorgesehen sind, wobei an einem Belag die Eingänge (E1, E2) und an einem zweiten Belag Gleichrichterschaltungen aus entgegengesetzt gepolten Dioden (7, 8, 9, 10) angeschlossen sind, die mit Glättungsschaltungen aus Kondensatoren (11, 12) mit 4 diagonal gegenüberliegenden Anschlüssen und Zener-Dioden (15, 16) zur Stabilisierung verbunden sind, die an eine Oszillatorschaltung (17) vor dem Ausgang angeschlossen sind. Jeweils ein Eingang ist an einer anderen logischen Verknüpfungsschaltung seriell geschleift. Die Dotierung wird so gewählt, daß die zur Erzeugung der Eingangswechselspannungssignale verwendete Batteriespannung jeweils die entgegengesetzte Polung zu den von der Oszillatorschaltung benötigten und in Abhängigkeit von den Wechselspannungssignalen durch die Eingangskondensatoren und Gleichrichterschaltungen erzeugten Betriebsspannungen aufweist.

FIG.1

Licentia-Patent-Verwaltungs-GmbH
Theodor-Stern-Kai 1
D-6000 Frankfurt 70

Fehlersichere logische Verknüpfungsschaltung

Die Erfindung betrifft eine Schaltungsanordnung nach dem Oberbegriff des Patentanspruchs 1.

Es ist bereits eine Schaltungsanordnung zur logischen Verknüpfung wechselspannungsförmiger Eingangssignale zu einem wechselspannungsförmigen Ausgangssignal bekannt, bei der die Eingangssignale getrennten Eingangsübertragern zugeführt und in deren Sekundärkreisen eingeschaltete Gleichrichteranordnungen gleichgerichtet werden, die gleichgerichteten Eingangssignale die einzelnen Steuerpotentiale für eine nachgeschaltete Transistorsperrschwingerschaltung mit Rückkopplungsübertrager bilden, und die Impulsspannung des Sperrschwingers über eine in den Sekundärkreis des Rückkopplungsübertragers eingeschaltete Verstärkerstufe dem Ausgang zugeführt wird (Patent 19 33 713).

Solche Schaltungsanordnungen, die zu logischen UND-, ODER-, NICHT-, Speicher- bzw. Verzögerungsgliedern ausgestaltet werden können, werden für den Einsatz in fehlersicher arbeitenden Anlagen benötigt. Sie dienen zu Steuerungsaufgaben sowie Überwachungen mit Sicherheitsverantwortung.

Die oben beschriebene Schaltungsanordnung ist jedoch für eine höhere Datenverarbeitungsgeschwindigkeit zu langsam. Der Herstellungsaufwand ist noch zu teuer und die so hergestellten Moduln noch zu groß.

Die Aufgabe besteht daher darin, eine Schaltungsanordnung zur logischen Verknüpfung wechselspannungsförmiger Eingangssignale zu schaffen, die für höhere Datenverarbeitungsgeschwindigkeiten brauchbar und kostengünstig herstellbar ist. Durch geringfügige Schaltungsänderungen sollen daraus alle beliebigen Logikfunktionen realisierbar sein und die Moduln sollen failsafe-Eigenschaften besitzen.

Die Aufgabe wird nach der Erfindung durch die in den Patentansprüchen angegebenen Maßnahmen gelöst.

Die Erfindung wird im folgenden anhand von Zeichnungen an einem Ausführungsbeispiel näher erläutert.

Die Grundschaltung V besteht aus den Eingängen E1 und E2, wobei die Klemme 2 des Eingangs E1 mit einem Eingang einer weiteren logischen Grundschaltung V seriell verschleift ist, während an die Klemme 1 ein Wechsel-spannungssignal von einem Ausgang einer weiteren Grundschaltung V gelegt wird. Desgleichen ist an die Klemme 3
des Eingangs E2 ein Wechselspannungssignal geführt,
während die Klemme 4 mit einer weiteren Grundschaltung
seriell verschleift ist. Diese weiteren Verknüpfungsschaltungen sind nicht dargestellt. Die Klemmen 1, 2 bzw.
3, 4 sind mit je einem Belag zweier Kondensatoren 5, 6
verbunden. Die Kondensatoren 5, 6 dienen zur galvanischen
Trennung. Die zwei Anschlüsse auf einem Belag liegen
einander diagonal gegenüber. Die zweiten Beläge der Kondensatoren 5, 6 besitzen ebenfalls je zwei Anschlüsse.
Auch diese Anschlüsse liegen einander diagonal gegenüber, jedoch so, daß die Diagonalen des ersten und des
zweiten Belages senkrecht aufeinanderstehen. Bei einer
solchen Anordnung führt jede Beschädigung des Kondensators zu seinem völligen Ausfall. Die serielle Verschleifung der Eingänge dient zur Erzeugung der Betriebsspannung der Grundschaltung V.

Es ist auch möglich, anstelle der Kondensatoren 5 und 6
Optokoppler zur galvanischen Trennung der Ein- und Ausgangssignale zu verwenden.

An die zweiten Beläge sind entgegengesetzt gepolte Dioden 7, 8, 9, 10 angeschlossen. Es folgt jeweils eine
Gleichrichtung mit Potentialumkehr sowie eine Siebung
und Spannungsbegrenzung. Die so aus den Eingangssignalen
gewonnenen Gleichspannungssignale werden als Stromversorgung einer Halbleiter-Oszillatorschaltung zugeführt.
Durch diese Dioden 7, 8 werden die wechselspannungsförmigen Eingangssignale gleichgerichtet und sind mit nachfolgenden Glättungsschaltungen aus Kondensatoren 11, 12 mit vier diagonal gegenüberliegenden Anschlüssen verbunden. Zwischen die Dioden und die Kondensatoren 11, 12 können noch - nicht dargestellte - Erweiterungseingänge gelegt werden.

An einem Belag der Kondensatoren 11, 12 sind Stabilisierungsschaltungen, bestehend aus Widerständen 13, 14 sowie Zener-Dioden 15, 16 angeschlossen. Diese sind an Null-Potential gelegt.

Das gleichgerichtete, geglättete und stabilisierte Signal wird einer Halbleiter-Oszillatorschaltung 17 zugeleitet, die von ihm angestoßen und zum Schwingen angeregt wird. Sind die erforderlichen, von den Eingangssignalen abgeleiteten Versorgungsspannungen für den Oszillatorkreis nicht vorhanden, so kann dieser nicht schwingen. Das im Oszillatorkreis erzeugte Wechselstromsignal wird galvanisch entkoppelt abgegriffen. Die Halbleiter-Oszillatorschaltung 17 ist mit einem Verstärker 18 verbunden, der das nun wieder zu einer Wechselspannung umgeformte Signal verstärkt, umpolt und auf den Ausgang A gibt.

Beim Auftreten einer beliebigen Störung an der Schaltungsanordnung, z.B. durch Bauelementeausfall, Kurzschluß oder Unterbrechung kann kein Signal am Ausgang A ausgegeben werden. Das gleiche gilt für Änderungen der Widerstandswerte zwischen 0 bzw. gegen $\infty$ . Bei einem Kurzschluß der Gleich-

richterdioden werden die übertragenen Eingangssignale
durch den hohen Widerstand der Kapazitäten stark gedämpft,
so daß die Halbleiter-Oszillatorschaltung ebenfalls nicht
ausschwingen kann. Die Ausgabe eines Fehlsignals wird somit verhindert.

Eine derartige Schaltungsanordnung ist nicht auf die Realisierung einer bestimmten logischen Verknüpfung beschränkt,
sondern ermöglicht den Aufbau eines Systems mit allen erforderlichen Verknüpfungsarten. Durch variierten Aufbau
der Halbleiter-Oszillatorschaltung 17 lassen sich UND-,
ODER-, NICHT-, Speicher-, Verzögerungs- u.a. logische Verknüpfungsglieder realisieren.

Besonders vorteilhaft wirkt sich bei der Schaltungsanordnung nach der Erfindung aus, daß zwischen den Eingängen
und dem Ausgang Potentialtrennung besteht, und daß sie infolge Fehlens einer eigenen Versorgungsspannung bzw. eines
Taktsignals im Ruhestand nicht aktiviert, d.h. passiv ist.
Außerdem läßt die Schaltungsanordnung einen Fehler an sämtlichen Bauelementen zu, sei es durch Kurzschluß oder Unterbrechung, ohne daß ausgangsseitig ein möglicherweise falsches Signal entstehen kann.

Typisch für alle Grundschaltungen V ist, daß die Oszillatorschaltungen keine eigene Stromversorgung besitzen, sondern die notwendige Energie ausschließlich aus den zu verarbeitenden Eingangssignalen und somit von den Ausgängen
der vorgeschalteten Grundschaltungen erhalten. Ein Durchstoßen der Eingangssignale auf den Ausgang (im Fehlerfall) ist durch die gewählte Potentialumkehr innerhalb des Moduls ausgeschlossen. Ein galvanischer Schluß in den Eingangskondensatoren kann nicht zu einem gefährlichen Ausgangssignal führen, da die Dotierung des im Oszillators verwendeten Halbleiters so gewählt ist, daß er zur Eingangsspannung jeweils die entgegengesetzte Polung zu der Oszillatorspannung benötigt.

Die Schaltungsanordnung nach der Erfindung ist kostengünstig, erlaubt eine höhere Verarbeitungsgeschwindigkeit bei kleineren Abmessungen der zu fertigenden Moduln sowie eine höhere Verknüpfungsdichte je Steckkarte.

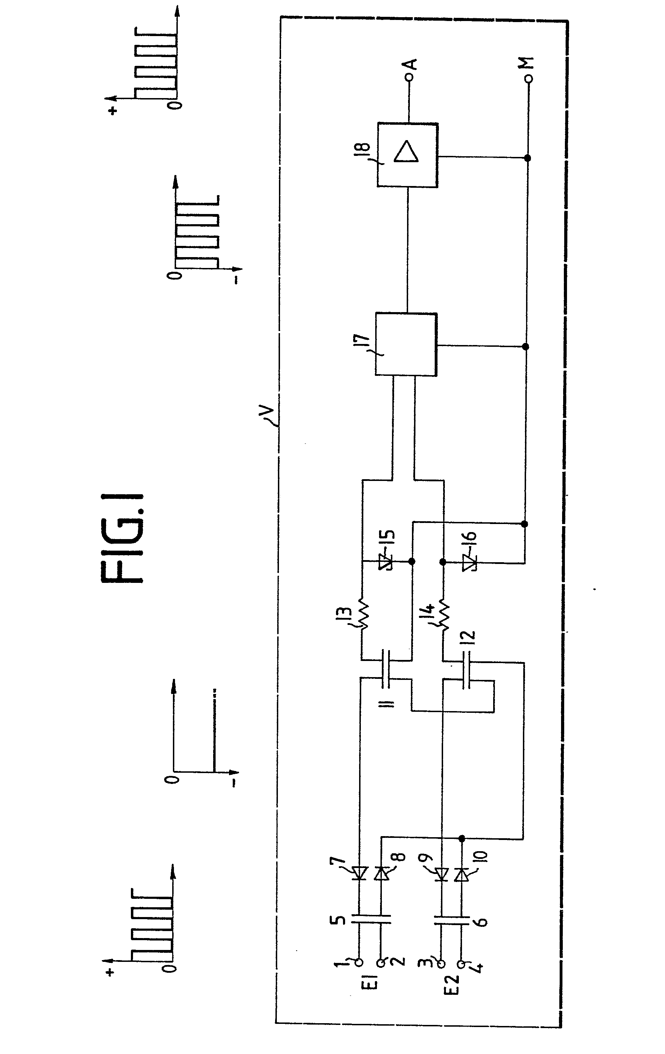

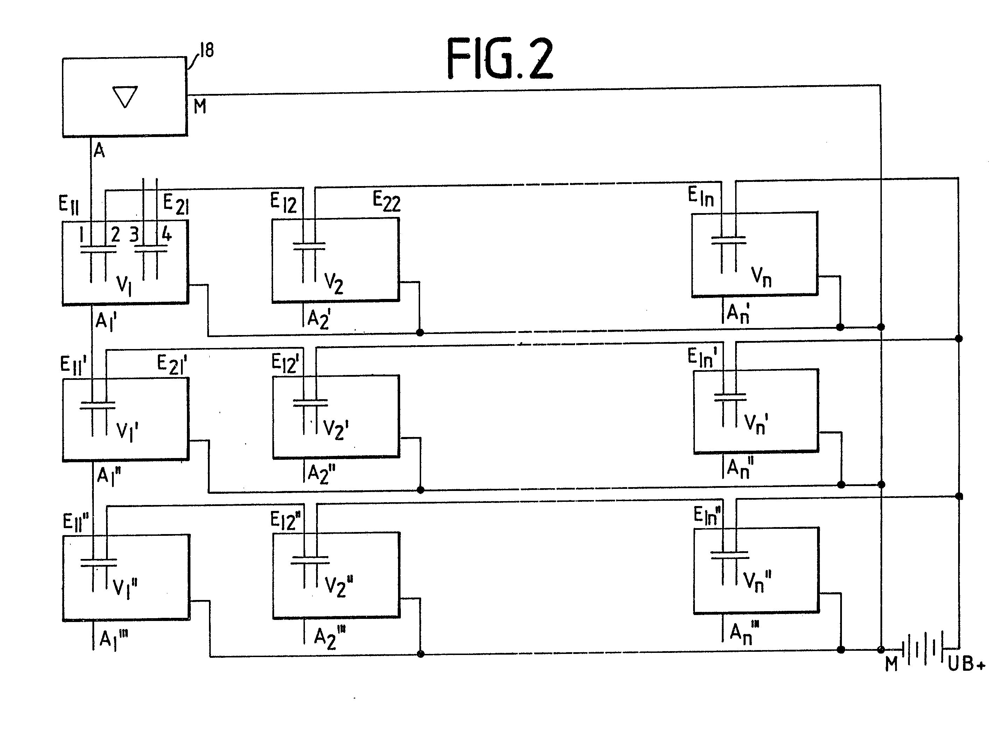

Anhand der Figur 2 wird ein Ausführungsbeispiel der Verknüpfung von Grundschaltungen V erläutert.

Die einzelnen Grundschaltungen sind mit V, ($V_1$, ..., $V_n$, $V_1'$, ..., $V_n''$ ,,) bezeichnet.

Eine intern im Verstärker 18 einer Grundschaltung V erzeugte Schwingung wird über einen Koppel-Kondensator K ausgekoppelt und durch die Transistorstufe T, die ihre Versorgungsspannung $U_B$ über die in Serie geschalteten Belege der Eingangskondensatoren 5, 6, ... der der ersten Grundschaltung nachgeschalteten $V_1$, ..., $V_n$ erhält, verstärkt auf den Ausgang A gegeben.

Die Eingangskapazitäten 5, 6 ... stellen einen Teil des Kollektorwiderstandes dar. Der durch die intern in der ersten Grundschaltung erzeugte Schwingung getaktete Kollektorstrom stellt das Eingangssignal für die Eingänge $E_{11}$, ..., $E_{1n}$ der dem Modul V nachgeschalteten Moduln $V_1$, ..., $V_n$ dar.

Jedes Modul besitzt eine oder auch mehrere Ausgangsverstärkerstufen 18 (bei mehreren Ausgängen) der oben beschriebenen Art. Der Übersicht halber ist dies nur für das Modul V eingezeichnet. Aus dem gleichen Grunde ist in der Figur darauf verzichtet worden, für die einzelnen Verknüpfungsglieder jeweils weitere Eingänge oder Ausgänge, die wiederum mit noch anderen (nicht gezeichneten) logischen Bausteinen verknüpft sind, anzugeben. Es sind beliebige Verzweigungen denkbar.

Die zu verarbeitenden Signale werden über anpassende Eingangsbausteine in die aus Grundschaltungen gebildete Logikkonfiguration eingegeben und über anpassende Ausgangsbausteine ausgekoppelt.

In dem Beispiel der Figur 2 steuert das Modul V die Bausteine $V_1$, ..., $V_n$ mit dem gleichen Signal an, wobei wiederum das von $V_1$ ausgegebene Signal die Moduln $V_1'$, ..., $V_n'$ ansteuert usw.

Die Batteriespannung $U_B$ ist so gewählt, daß sie jeweils die entgegengesetzte Polung zu den in den Oszillatorschaltungen der Moduln $V_1$, ..., $V_n$ bzw. $V_1'$, ..., $V_1''$ $V_1''$, ..., $V_n''$ benötigten Betriebsspannungen der dort verwendeten Transistoren aufweist.

werden beispielsweise in den Verknüpfungsgliedern für die Oszillatoren p n p - Transistoren mit einer dieser Dotierung entsprechenden negativen Betriebsspannung (abgeleitet aus den Eingangssignalen nach Gleichrichtung und Glättung) verwendet, muß $U_B$ positiv sein.

Die erfindungsgemäße Lösung erlaubt es, aufwendig und kostspielige konstruktive Maßnahmen bei der Fertigung der Kondensatoren zur Vermeidung von Isolationsfehlern zu umgehen und bietet darüber hinaus mehr Sicherheit, da bei noch so großen konstruktiven Anstrengungen ein Defekt der Kondensatoren nie ausgeschlossen werden kann. Das Fertigungsverfahren der Moduln läßt sich kostengünstig durchführen, da die Bauelemente (Kondensatoren, Widerstände) auf Keramiksubstrat gedruckt werden können. Weiterhin ist es von Vorteil, daß durch die Serienschaltung der Kondensatoren eine fehlersichere Kopplung der Eingänge miteinander garantiert wird. Bei Verdrahtungsunterbrechung ergibt sich für alle in Reihe geschalteten Eingänge O-Signal.

Licentia-Patent-Verwaltungs-GmbH
Theodor-Stern-Kai 1
D-6000 Frankfurt 70


Patentansprüche


1. Schaltungsanordnung zur logischen Verknüpfung wechselspannungsförmiger Eingangssignale zu einem wechselspannungsförmigen Ausgangssignal durch Gleichrichtung der Eingangssignale zu einem Gleichstromsignal, das eine Schwingungsschaltung mit Verstärker steuert, dadurch gekennzeichnet, daß an den Eingängen zur galvanischen Trennung Kondensatoren mit 4 diagonal gegenüberliegenden Anschlüssen vorgesehen sind, wobei an einem Belag die Eingänge und an einem zweiten Belag Gleichrichterschaltungen aus entgegengesetzt gepolten Dioden angeschlossen sind, die mit Glättungsschaltungen aus Kondensatoren mit 4 diagonal gegenüberliegenden Anschlüssen und Zener-Dioden zur Stabilisierung verbunden sind, die an eine Oszillatorschaltung vor dem Ausgang angeschlossen sind, und daß jeweils ein Eingang an einer anderen logischen Verknüpfungsschaltung seriell geschleift ist.

2. Schaltungsanordnung nach Anspruch 1, dadurch gekennzeichnet, daß durch geringfügige Schaltungsänderungen bzw. -ergänzungen jede beliebige Logikfunktion realisierbar ist.

3. Schaltungsanordnung nach Ansprüchen 1 und 2, dadurch gekennzeichnet, daß die Dotierung des in der Oszillatorschaltung verwendeten Halbleiters so gewählt wird, daß die zur Erzeugung der Eingangswechselspannungssignale verwendete Batteriespannung jeweils die entgegengesetzte Polung zu den von der Oszillatorschaltung benötigten und in Abhängigkeit von den Wechselspannungssignalen durch die Eingangskondensatoren und Gleichrichterschaltungen erzeugten Betriebsspannungen aufweist.

FIG.1

0049679

# FIG.2

2/2

0049679

Europäisches
Patentamt

**EUROPÄISCHER RECHERCHENBERICHT**

| | EINSCHLÄGIGE DOKUMENTE | | KLASSIFIKATION DER ANMELDUNG (Int Cl ) |
|---|---|---|---|
| Kategorie | Kennzeichnung des Dokuments mit Angabe. soweit erforderlich. der maßgeblichen Teile | betrifft Anspruch | H 03 K 19/007 |
| | DE - A - 2 425 303 (LICENTIA PATENT VERWALTUNG)<br><br>* Figuren 1,2; Seite 4, Zeile 5 - Seite 9, Zeile 11 *<br><br>-- | 1-3 | |
| | DE - A - 2 544 427 (LICENTIA PATENT VERWALTUNG)<br><br>* Figuren; Seite 6, Zeile 17 - Seite 11, Zeile 5 *<br><br>-- | 1-3 | |
| | US - A - 4 125 784 (HARRISON)<br><br>* Figuren; Spalte 5, Zeile 64 - Spalte 6, Zeile 5 *<br><br>-- | 1 | RECHERCHIERTE SACHGEBIETE (Int. Cl.³)<br><br>H 03 K 19/007<br>19/003<br>19/08 |
| | DE - A - 2 244 798 (BROWN BOVERI)<br><br>* Figuren 1,2; Seite 1, Zeile 1 - Seite 5, Zeile 4 *<br><br>---- | 1 | |

KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsatze
E: kollidierende Anmeldung
D: in der Anmeldung angefuhrtes Dokument
L: aus andern Gründen angeführtes Dokument
&: Mitglied der gleichen Patentfamilie. übereinstimmendes Dokument

Der vorliegende Recherchenbericht wurde für alle Patentansprüche erstellt.

| Recherchenort<br>Den Haag | Abschlußdatum der Recherche<br>09-12-1981 | Prufer<br>FEUER |
|---|---|---|

EPA form 1503.1   06.78